# EUROPEAN PATENT APPLICATION

(11) **EP 4 615 173 A1**
(43) Date of publication of application: **10.09.2025**
(21) Application number: 24162174.7
(22) Date of filing: 07.03.2024
(51) Int. Cl.: H05K 1/18, H05K 3/28, H05K 3/30

(54) **COMPONENT CARRIER WITH RESIN-EMBEDDED COMPONENT, AND MANUFACTURING METHOD**

(71) Applicant: AT & S Austria Technologie & Systemtechnik Aktiengesellschaft, 8700 Leoben-Hinterberg (AT)
(72) Inventor: Candic, Kenad, 8041 Graz (AT); Zluc, Andreas, 8700 Leoben (AT); Stahr, Johannes, 8605 St. Lorenzen (AT)
(74) Representative: Dilg, Haeusler, Schindelmann Patentanwaltsgesellschaft mbH

(57) **Abstract**

There is described a component carrier (100) comprising:
i) a stack (101) having at least one electrically conductive layer structure (104) and at least one electrically insulating layer structure (102);
ii) a cavity (120) in the stack (101);
iii) a component (110) embedded in the cavity (120); and
iv) a first resin (130) extending from a bottom of the cavity (120) to at least part of the lateral side of the component (110) defining an external boundary surface (130);

The component (110) comprises an external main surface (112) opposite to the bottom of the cavity (120), wherein the external boundary surface (130) is vertically misaligned with respect to the external main surface (112) of the component (110).

## Description

### Field of the Invention

The invention relates to a component carrier with a stack having at least one electrically conductive layer structure and at least one electrically insulating layer structure, a cavity, a component embedded in the cavity, and a resin extending from a bottom of the cavity to at least part of the lateral side of the component, thereby defining an external boundary surface. The invention further relates to a method of manufacturing said component carrier.

Accordingly, the invention may relate to the technical field of component carriers, such as printed circuit boards or IC substrates, and their manufacture.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. Also an efficient protection against electromagnetic interference (EMI) becomes an increasing issue. At the same time, component carriers shall be mechanically robust and electrically and magnetically reliable so as to be operable even under harsh conditions.

In particular, embedding a component into (the layer stack) of such a component carrier may still be seen as a challenge.

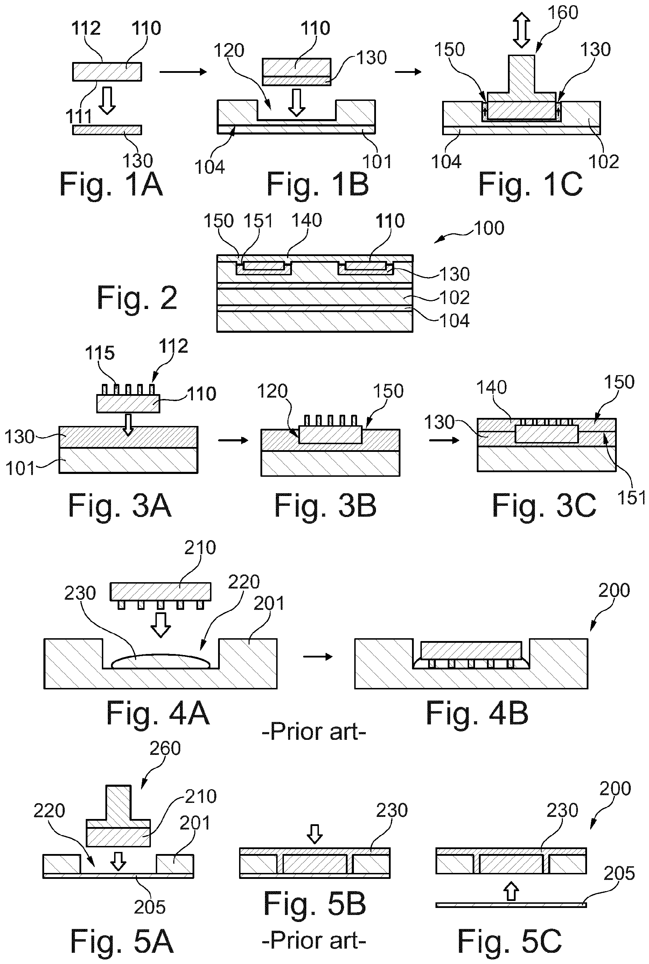

**Figures 4A and 4B** show a first conventional approach to embed a component 210 in a cavity 220 of a stack 201 of a circuit board 200. A non-conductive film (NCF) is used as a glue 230 and dispensed at the bottom of the cavity 220. The component 210 is placed in the cavity 220 and sticked with the glue 230 to the cavity 220. The flow of the glue 230 is very low and only distributed at the bottom of the bottom of the cavity 220. Due to the low material flow, there is a low planarity control between the component 210 and the stack surface. Thus, the top of the component 210 and the top of the cavity edge may not be arranged at the desired vertical heights.

**Figures 5A to 5C** show a second conventional approach to embed a component 210 in a cavity 220. The cavity 220 is formed as a through-hole and a temporary thin foil 205 is applied to close the bottom of the cavity 220. The component 210 is placed in the cavity 220 with a suitable pressing device 260. In the next step, the component 220 is encapsulated in a resin 230. Finally, the temporary thin foil 205 is removed to yield a circuit board 200 with an embedded component 210. In comparison to the example of Figures 4A and 4B, the top of the component and the top of the cavity edge may be arranged at the same vertical height (but only at the same). However, the process according to Figures 5A to 5C needs several process steps and requires cost and effort.

### Summary of the Invention

There may be a need to embed a component in a cavity of a component carrier in an efficient and reliable manner.

A component carrier and a manufacturing method are described.

According to a first aspect of the invention, there is described a component carrier, comprising:
i) a stack having at least one electrically conductive layer structure and/or at least one electrically insulating layer structure,
ii) a cavity (formed) in the stack,
iii) a component embedded in the cavity (in the stack), and
iv) a first resin (e.g. a fiber-free resin and/or a (glass) filler resin, such as ABF) extending from a bottom of the cavity to at least part of the lateral side (sidewall) of the component, thereby defining an external boundary surface.
In particular, the component comprises an external main surface opposite to (away from) the bottom of the cavity, wherein the external boundary surface is vertically (in the Z-direction, parallel to the stacking/thickness direction) misaligned (in other words: not flush) with respect to the external main surface of the component (in other words: the external boundary surface of the first resin is at a different vertical height than the external main surface of the component).

According to a second aspect of the invention, there is described a method of manufacturing a component carrier, wherein the method comprises:
i) providing a stack having at least one electrically conductive layer structure, at least one electrically insulating layer structure, and a cavity,
ii) embedding the component in the cavity, and
iii) providing a first resin to the component and/or a bottom of the cavity, so that

a) the first resin extends from the bottom of the cavity to at least part of the lateral side of the component, thereby defining an external boundary surface,
b) the component comprises an external main surface opposite to the bottom of the cavity, and
c) the external boundary surface is vertically misaligned (offset) with respect to the external main surface of the component.

According to a further aspect of the invention, there is described a component carrier, comprising:
i) a stack having a plurality of electrically conductive layer structures and electrically insulating layer structures forming a build (-up) structure, wherein said build (-up) structure comprises a cavity,
ii) a component embedded in the cavity (in the stack), and
iii) a first resin (e.g. a fiber-free resin such as ABF) extending from a bottom of the cavity to at least part of the lateral side (sidewall) of the component, thereby defining an external boundary surface.
In particular, the component comprises an external main surface opposite to (away from) the bottom of the cavity, wherein the external boundary surface is vertically (in the Z-direction, parallel to the stacking/thickness direction) misaligned (in other words: not flush) with respect to the external main surface of the component (in other words: the external boundary surface of the first resin is at a different vertical height than the external main surface of the component).

In the present context, the term "component carrier" may refer to a final component carrier product as well as to a component carrier preform (i.e. a component carrier in production, in other words a semi-finished product). In an example, a component carrier preform may be a panel that comprises a plurality of semi-finished component carriers that are manufactured together. At a final stage, the panel may be separated into the plurality of final component carrier products.

In an embodiment, the component carrier "stack" comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components. In an example, the stack may be nevertheless very thin and compact. In another example, the stack may be very thick for a high density product. The stacking direction (height/thickness) may be arranged in the vertical direction z. Further, the stacking direction may be perpendicular to the two directions of main extension (along x and y) of the (plate-shaped) component carrier.

In the context of the present application, the term "main surface" of a body may particularly denote one of two largest opposing surfaces of the body. The main surfaces may be connected by circumferential side walls. The thickness of a body, such as a stack, may be defined by the distance between the two opposing main surfaces.

In an example, all layers of the component carrier may form the stack. In another example, only a part of the layers of the component carrier form the stack. In this context, the term "layer structure" may in particular refer to a continuous or discontinuous layer (or separated islands within the same plane) of electrically conductive or electrically insulating material. A plurality of such layers, parallel stacked one upon the other, may form the stack in the vertical direction.

In an embodiment, the term "first resin" may in particular refer to a resin material arranged in a cavity (in a stack) of a component carrier. The first resin material may be a non-reinforced or a reinforced resin. If the resin is reinforced this may be done in a fiber or fiber-free manner. In an embodiment, particles (in particular spheres) may be applied as a reinforcement material. In a specific embodiment, the first resin may comprise Ajinomoto build-up film (ABF). In the manufacture process, the first resin may be provided to the component and/or the cavity, before the component is placed in said cavity. For example, at least one main surface of the component may be covered by first resin and is then placed (and pressed) in the cavity. In another example, at least the bottom of the cavity may be filled by first resin, and then the component is placed on (and pressed into) the first resin in the cavity. The first resin may be configured to be at least partially flowable (not fully cured), so that the component can be pressed partially into the first resin material. Furthermore, the first resin may be configured to extend (in the vertical direction) partially along the sidewall(s) of the embedded component.

In an embodiment, the term "external boundary surface" may in particular refer to a region/portion of the first resin in the cavity. When the component is at least partially pressed into said first resin material, a part of the first resin material may extend (be pressed) upwards along the lateral wall of the component up to a specific vertical level. Said vertical level (up to which the first resin extends in the cavity) may be termed the external boundary surface of the first resin. When further embedding the component (e.g. by laminating a second resin on top), a contact region may be formed at the external boundary surface.

According to an exemplary embodiment, the invention may be based on the idea that a component may be embedded in a component carrier cavity in an efficient and reliable manner, when the component is placed in the cavity such that a first resin (e.g. a fiber-free resin such as ABF) extends from a bottom of the cavity to at least part of the lateral side of the component, thereby defining an external boundary surface. This structure may reflect a manufacture in which the flow of the first resin is efficiently controlled. To achieve such a control to adjust the flow (and filling height in the cavity) of the resin, several properties may be taken into account, e.g. material of the first resin, temperature/pressure conditions during manufacture, polymerization degree of the first resin, type/shape/amount of reinforcement material, etc.

In a first manufacture process (see e.g. Figure 1), the first resin may be attached to the component and the component is then pressed into the cavity such that the first resin flows to the lateral walls of the component. In a second manufacture process (see e.g. Figures 3B and 3C), the first resin may be laminated onto the stack (or only into the cavity), and the component is pressed (partially) into said first resin, thereby forming a cavity. In a specific example, the component itself is also able to create a cavity during the assembling process.

It has been surprisingly turned out that such manufacture steps may be straightforward and highly cost- and effort-efficient. Taking one or more resinassociated properties/conditions into account, the first resin flow may be adjusted to achieve a specific vertical height (external boundary surface) relative to the component in the cavity, e.g. flush with the surface of the stack at the upper edge of the cavity.

In particular, the component comprises an external main surface opposite to the bottom of the cavity, wherein the external boundary surface is vertically misaligned (in other words: not flush) with respect to the external main surface of the component. Thereby, an efficient and robust basis may be provided to enable further covering by a second resin.

In particular, the described approach may improve the accuracy of component placement (in particular vertical height).

### Exemplary Embodiments

In an embodiment, the component carrier further comprises: a second resin (in particular a resin layer structure, for example reinforced or non-reinforced, in particular fiber-reinforced). One side (in particular the side opposed to the main surface of the second resin layer structure away from the component) of the second resin is in contact with at least one of the component, one of the layer structures of the stack, and the first resin; thereby defining an internal boundary surface. In an embodiment, the internal boundary surface and the external boundary surface define a respective contact region (where they are in physical contact with each other). This may provide the advantage that a robust and efficient embedding is enabled. The second resin can function as a protection to the embedded component, for example like a protective lid. Since the external boundary surface of the first resin is vertically misaligned with the external main surface of the component, the free space between these surfaces may be efficiently filed with the second resin. Preferably, the internal boundary surface and the external boundary surface may have a respective shape like a key-lock (positive/negative) pattern, in order to ensure good adhesion with each other.

In an embodiment, the first resin is cured before the second resin. In an embodiment, the internal boundary surface and the external boundary surface are defined by the first resin and the second resin cured one before the other. This process step may be recognizable in the final component carrier product (product-by-process) through the contact region, defined by the two boundary surfaces (external boundary surface and internal boundary surface). Said contact region (interface) may be formed because the second resin, before complete curing, flows against the external boundary surface/profile of the already cured first resin. Hence, said contact region may be distinguishable through a cross section of the component carrier. By curing the first resin in the first place, the component may be positioned/embedded in a more stable and precise manner. When the second resin is added, the component is already securely fixed in its desired position and not removed/disturbed by the flowing second resin.

In an embodiment, the bottom portion of the cavity, in particular facing the component (first main surface of the component), is fully filled with the first resin. This may provide the advantage that the component can be placed directly on the (not fully cured) first resin and gets fixed in the cavity in a flexible manner. In other words, the first resin in the cavity functions as an adhesive to fix the component. The component can be pressed into the first resin in a smooth manner, thereby avoided potential damages to the component.

In an embodiment, the component can be pressed into the middle of the lateral direction of the cavity, such that the force received by component could be equal from two lateral directions. Thus, the component can be placed to desired position without shifting.

In an embodiment, the first resin extends only around (not on) the component. In an embodiment, the upper surface (facing away from the component) of the layer structure of the stack, defining the edge of the cavity, is free of the first resin. The term "edge of the cavity" may denote in this context the edge composed by the lateral wall of the cavity intersecting with the upper surface of the layer structure defining the cavity boundary surface. Thus, the first resin is used to fix the component and embed the bottom and at least part of the sidewalls of the component. Yet, it may be not desired to also cover the top of the component (upper main surface). This may provide the advantage that a clearly defined external boundary surface is provided onto which a second resin may be efficiently placed to cover the top of the component.

In an embodiment, the component carrier further comprises a core layer structure in the stack, wherein the component and the cavity are arranged at least partially in said core layer structure. A core layer structure may comprise a robust material such as fully cured resin (e.g. FR4), an inorganic layer structure (e.g. glass, ceramics, semiconductor material), or a metal. Such a core layer structure may be a common measure to increase the stability of a component carrier. Thus, the core layer structure may be especially suitable to securely embed a component.

In an embodiment, the component carrier further comprises a build-up structure (a plurality of electrically insulating layer structures and electrically conductive layer structures) in the stack, wherein the component and the cavity are arranged at least partially in said build-up structure. This embodiment may increase the design flexibility, because the component may be embedded in a flexible manner at the desired location. The term "build up" may refer in this context to a plurality of layer structures stacked on top of each other. These layers may be thinner than a core layer structure. A build-up can be done on top (or below) such a core layer structure. While the build-up layers are normally formed by lamination (and are hence not fully cured), the core layer structure is may comprise fully cured material.

In an embodiment, a first (external main) surface of the component, oriented towards a bottom of the cavity, is fully covered by the first resin. In other words, the bottom part of the component is fully immersed in first resin, thereby increasing the stability of the embedding process.

In an embodiment, the external boundary surface is provided at the side of the component that is in contact with the second resin. Thereby, a contact region can be formed between first resin and the second resin at the lateral wall (sidewall) of the component.

In an embodiment, the component carrier further comprises: residues of the first resin are provided/arranged at the (second) external main surface of the component and/or at one side of the one of the layer structures being in contact with the second resin. These structural features may reflect a manufacture step of pressing the component in the (not fully cured) first resin (before adding the second resin). The residues may result from spills of the not fully cured first resin during the embedding/encapsulating process, preferably subsequently removed from the external main surface of the component, but remaining in small, preferably randomly, distributed spots.

In an embodiment, the external main surface of the component is misaligned (e.g. 1 to 5 µm, in particular +/- 2 µm) with respect to an adjacent layer structure of the stack (in particular the one of the layer structures in contact with the second resin), which defines the cavity (in particular the upper edge of the cavity). In an embodiment, the (second, upper) external main surface of the component is below/above the adjacent layer structure of the stack (in particular the layer structure in contact with the second resin), which defines the cavity (in particular the upper edge of the cavity). In other words, the external main surface of the component is not flush with the upper main surface/edge of the cavity. This may enable a more robust embedding, since the component is fully placed in the cavity, thereby increasing the protection.

In an embodiment, a portion of the first resin overlaps and is in contact with the first/second external main second surface of the component. As described above for the residues, such a contact may reflect a manufacture step of pressing the component in not fully cured first resin, thereby eventually producing spills of first resin that can then (partially) overlap upper parts of the component.

In an embodiment, the component comprises a surface with an electrically connecting portion, in particular a pad/terminal, at the second external main surface of the component. This may provide the advantage that electric contacts of the component can be easily accessed (arranged opposed to the bottom of the cavity) for further applications.

In an embodiment, the top of the component is free of first resin material. Thus, an electrical connection to the top of the component may be provided without additional process steps.

In an embodiment, the electrically connecting portion is flush with the (second external main) surface of the component. In an embodiment, the electrical connecting portion, in particular a pillar, protrudes from the surface of the component, in particular at least partially extending through the second resin (see e.g. Figure 3C). Thereby, the design and application flexibility may be increased. Embedding the electrically connecting portions in second resin may increase the reliability of these contacts.

In an embodiment, the component carrier further comprises a further layer structure on the second resin. In an embodiment, the space between the second resin and the component/adjacent layer is free of the further layer structure. In an embodiment, the further layer structure can be either electrically conductive or electrically insulating. The further layer structure may stabilize the embedded component, e.g. by covering the second resin. The further layer structure can also be a further layer of a build-up structure. The further layer structure can also be a solder resist and/or a surface finish. In an embodiment, the second resin (layer structure) may have only the function to planarize the misalignment between the component and the adjacent layer. The further layer structure may then serve for the stabilisation/further build-up.

In an embodiment, an electrically conductive layer structure (being different from the further layer structure) is connected on the surface of the component and/or to the layer structure adjacent to the component. In an embodiment, the (further) electrically conductive layer structure extends at least partially through the second resin. Thereby, an efficient and reliable electrical connection of the component may be enabled. For example, the second resin (and the further layer structure) may serve as a protection to the connecting portions of the component, while the electrically conductive layer structure may serve for electrically contacting. In an embodiment, the electrically conductive layer structure may extend at least partially through the second resin and/or the further layer structure.

In an embodiment, the external boundary surface extends along the direction between the component and the cavity profile defining a rounded shape, in particular a convex shape or a concave shape (of the external boundary surface). This structural feature may reflect a manufacture step of pressing the component in first resin, so that a part of the first resin will move along the lateral wall of the component. As discussed above, the first resin may not move up to the upper main surface of the component, but stop on the way, thereby defining the external boundary surface. Said external boundary surface may not be planar, but may also be shaped rounded, e.g. concave/convex, depending on the process conditions. A rounded shape may enable a more stable connection with second resin (e.g. increasing the connection surface).

In an embodiment, the first resin comprises a resin material with reinforcement particles, in particular free of fibers, more in particular ABF. In an embodiment, the second resin comprises stack material, e.g. non-reinforced resin or prepreg). In an embodiment, the first resin and the second resin comprise the same material (e.g. ABF) or different materials. Depending on the desired application, different established materials may be directly applied. Providing a stack material (e.g. reinforced (in particular fiber) or non-reinforced resin) may improve the integrity of the second resin (and/or the first resin) in the (build-up) layer stack.

In an embodiment, the first resin is in contact with three, in particular five sides (upper main surface) of the component. Thereby, a robust embedding may be enabled.

In an embodiment, an angle between the surface of the component and a surface of a layer structure of the stack or a surface of the first resin is smaller than 2°. This feature may indicate that the difference in height is quite small in this example.

In an embodiment, when more than one component is embedded in more than one cavity, the difference level in stacking direction of respective top surface of the components is smaller than 2 µm. Thereby, a high integrity may be provided. Further, this measure may indicate a precise manufacture process.

In an embodiment, a plurality of components may have different thicknesses. In an embodiment, the top surfaces (far away from the bottom of cavity) of said plurality of components may still be (essentially) on the same level.

In an embodiment, the method further comprises: controlling the temperature and/or pressure to thereby adjust the properties of the first resin. Depending on the temperature/pressure conditions, the properties (in particular viscosity, flow behaviour) of the first resin may be controlled/regulated and adapted to specific applications. For example, a high accuracy assembling in z-axis (stack thickness direction), in particular when a vacuum may be applied.

In an embodiment, the method further comprises: providing a second resin, in particular a resin layer structure, so that the second resin is in contact with at least one of the component, one of the layer structures of the stack, and the first resin. Hence, the second resin may serve to compensate for the vertical misalignment.

In an embodiment, the first resin is (fully) cured before the second resin (is fully cured). See discussion above.

In an embodiment, wherein the component is an optical component and/or wherein the second resin comprises a translucent, in particular transparent, material.

In an embodiment, the component carrier comprises at least two components (see e.g. Figure 2) electrically connected to a bridge structure. Said embodiment may further comprise a driver, surface-mounted or also embedded.

In an exemplary embodiment, ABF sheets are applied to fix a component in a cavity. A homogeneous material is hereby used, and the same material as used for build-up (no mixed materials). The resin is placed directly on the backside of the component. By Z-Axis control, the component is placed in the cavity and fixed at defined position. A combination of chip assembly and cavity fixing (no additional lamination steps needed) may hence be realized.

In an embodiment, the component carrier is shaped as a plate. This contributes to the compact design, wherein the component carrier nevertheless provides a large basis for mounting components thereon. Furthermore, in particular a bare die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, socalled prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

In the context of the present application, the term "inorganic layer structure" may particularly denote a layer structure which comprises inorganic material, such as an inorganic compound. In particular, dielectric material of the inorganic layer structure or even the entire inorganic layer structure may be made exclusively or at least substantially exclusively from inorganic material. In another embodiment, the inorganic layer structure may comprise inorganic dielectric material and additionally another dielectric material. An inorganic compound may be a chemical compound that lacks carbon-hydrogen bonds or a chemical compound that is not an organic compound. In an example, the inorganic layer structure may comprise glass, for example silicon base glass, in particular soda lime glass, and/or boro-silicate glass and/or alumo-silicate glass and/or lithium silicate glass and/or alkaline free glass. In another example, the inorganic layer structure may comprise ceramic material, for example aluminum nitride and/or aluminum oxide and/or silicon nitride and/or boron nitride and/or tungsten comprising ceramic material. Yet, in another example, the inorganic layer structure may comprise semi-conducting material, for example silicon and/or germanium and/or silicon oxide and/or germanium oxide and/or silicon carbide and/or gallium nitride. In a further embodiment, the inorganic layer structure may comprise (elemental) metal and/or metal alloys, for example, copper and/or tin and/or bronze. Yet in another embodiment, the inorganic layer structure may comprise inorganic material, which is not listed in the above mentioned example, such as: MoS2, CuGaO2, AgAlO2, LiGaTe2, AgInSe2, CuFeS2, BeO.

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure (and/or the curable dielectric elements) comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE), polyvinylidene fluoride (PVDF) and/or a combination thereof. Reinforcing structures such as webs, fibers, spheres or other kinds of filler particles, for example made of glass (multilayer glass) in order to form a composite, could be used as well. A semicured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, carbon, platinum, (doped) silicon, and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component may be embedded in the component carrier and/or may be surface mounted on the component carrier. Such a component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al2O3) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga2O3), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable.

A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickelpalladium, etc.

### Brief Description of the Drawings

The aspects defined above and further aspects of the invention are apparent from the examples of embodiment to be described hereinafter and are explained with reference to these examples of embodiment.
Figures 1A to 1C illustrate a method of manufacturing a component carrier with a cavity, a component, and a first resin, according to an exemplary embodiment of the invention.
Figure 2 shows a side-view of a component carrier with two embedded components, according to an exemplary embodiment of the invention.
Figures 3A to 3C show a further method of manufacturing a component carrier with a cavity, a component, and a first resin, according to an exemplary embodiment of the invention.
Figures 4A and 4B show a first conventional approach to embed a component in a cavity.
Figures 5A to 5C show a second conventional approach to embed a component in a cavity.

### Detailed Description of the Drawings

**Figures 1A to 1C** illustrate a method of manufacturing a component carrier 100 with a cavity 120, a component 110, and a first resin 130, according to an exemplary embodiment of the invention.

Figure 1A: there is provided a component 110 comprising a first lower external main surface 111 and an opposed second upper external surface 112. Said component 110 is pressed partially onto a first resin 130, e.g. ABF material, so that (a part of) the first resin 130 sticks to the first external surface 111 of the component 110. The properties of the first resin during manufacture may controlled by varying the temperature/pressure. This process step may also be described as temperature-assisted pick-up.

Figure 1B: the component 110 with the first resin 130 is placed into a cavity 120 of the stack 101. The cavity 120 can be formed in a core layer structure. This process step may also be described as temperature-assisted placement.

Figure 1C: a pressing device 160 (here a stamp) is used to press (along the vertical direction, downwards) the component 110 deeper into the first resin 130 within the cavity 120. It is schematically illustrated by arrows that the first resin 130 starts flowing, moves along the bottom of the cavity 120 and up in a gap between a lateral sidewall of the component 110 and the lateral sidewall of the cavity 120. Hereby, the first resin 130 is not pressed up to the top of the component (second main surface 112) but stops the flow at a vertical height next to the component 110 sidewall, thereby defining an external boundary surface/region 150. This process step may also be described as placement on specified height with defined pressure/temperature. Additionally the pressing device 160 may be configured to pick/suck the component 110 with attached first resin 130 and place it/them into the cavity 120. Spills of the first resin 130 can be found on top of the component 110 and/or the stack 101.

**Figure 2** shows a side-view of a component carrier 100 with two components 110 embedded in a stack 101 with a plurality of electrically insulating layer structures 102 and electrically conductive layer structures 104, according to an exemplary embodiment of the invention. The components 110 have been embedded as described in Figures 1A to 1C or 3C. In comparison to Figure 1, a second resin (layer structure) 140 has been applied on top of the component 110, the cavity 120, and the surface of the upper layer of the layer stack 101. Reference sign 102 may denote here a core layer structure, while the component 110 is located in a build-up layer structure/stack.

One side of the second resin 140 is in contact with the component 110, one of the layer structures 102, 104 of the stack 101, and the first resin 130; thereby defining an internal boundary surface 151. It is indicated that the internal boundary surface 151 and the external boundary surface 150 define a respective contact region. This contact region is in particular formed due to the circumstance that the first resin 130 is cured before the second resin 140 is cured. Optionally, the second resin 140 is in contact with the component 110, the electrically insulating layer structures 102, the electrically conductive layer structure 104 of the stack 101, and the first resin 130. The bottom portion of the cavity 120, facing the component 110, is fully filled with the first resin 130, the first resin 130 extends only (partly) around the component 110. The second external main surface 112 of the component 110, the upper surface of the layer structure 102, 104 of the stack 101, defining the edge of the cavity 120, is free of the first resin 130. The contact region, at different position relative to the component (e.g. left of the component and right of the component) may be at the same vertical level or at different vertical levels.

In this example, the external main surface 112 of the component 110 is misaligned with respect to an adjacent layer structure of the stack 101, in particular the one of the layer structures 102, in contact with the second resin 140, which defines the upper edge of the cavity 120.

Further, it can be seen in this example, that the second resin 140 covers both components 110 and both cavities 120. The components 110 are hereby flush with each other.

The two components 110 can have similar or different size/shape and/or functionality. The top surface of the component can have the same or a different vertical height as the stack 101. The amount/concentration of reinforcement material at the internal boundary surface 151 may be different, in particular lower, than the bottom region of the cavity. This may be due to flow mechanics of the liquefied polymer. In an example, the first resin (material) 130 may be similar, in particular the same, as the second resin (material) 140. Alternatively, the first resin (material) 130 may be different than the second resin (material) 140. In an example, the first resin (material) 130 and/or the second resin (material 140) may comprise epoxy resin and/or poly(meth)acrylate and/or polyamide and/or polyimide and/or polytetrafluoroethylene. Additionally the first resin (material) 130 and/or the second resin (material) 140 may comprise reinforcing material, for example glass spheres and/or ceramic spheres.

**Figures 3A to 3C** show a further method of manufacturing a component carrier 100 with a cavity 120, a component 110, and a first resin 130, according to an exemplary embodiment of the invention.

Figure 3A: a stack 101 is provided that is covered at the upper main surface with a layer of first resin 130 (laminated core). The component 110 comprises at the second external main surface 112 a plurality of connecting portions 115 (e.g. copper pillars). In this example the plurality of connecting portions 115 are protruding out of the external main surface 112. Alternatively, the connecting portions 115 may be indented into the second external main surface 112. Said component 110 is now pressed (starting with the first external main surface 111) into the first resin 130 layer.

Figure 3B: the component 110 has been pressed into the first resin 130, so that the first resin 130 extends from a bottom of the cavity 120 (formed by the component 110 in the first resin 130) to at least part of the lateral side of the component 110, thereby defining the external boundary surface 150. Said external boundary surface 150 is vertically misaligned (not at the same height) with respect to the external main surface 112 of the component 110. Thus, an upper part of the component 110 and the connecting portions 115 on top of the second main surface 112 are exposed and free of the first resin 130. In other words, the component 110 is placed on the upper surface of the layer structure of the stack 101 and directly sticked on/in resin such as ABF.

Figure 3C: in a further step, the second resin 140 is formed on top of the first resin 130, the component 110, and the surface layer of the stack 101, e.g. by lamination. In this example, the second resin 140 is a resin layer formed of stack material (e.g. prepreg). It is indicated that the external boundary surface 150 of the first resin 130 and the internal boundary surface 151 of the second resin 140 form an interface region. The connecting portions 115 of the component 110 are encapsulated by the second resin material 140 and extend through the second resin 140.

A first resin 130 may be placed in the cavity 120. It may be possible that the lateral extension of the first resin 130 and the component 110 is different. Then, the component 110 is placed into the cavity 120 and the first resin (130) is squeezed out (compare Figure 1C).

### Reference signs

- 100: Component carrier
- 101: Stack
- 102: Electrically insulating layer structure
- 104: Electrically conductive layer structure
- 110: Component
- 111: First surface
- 112: Second surface
- 115: Electrically conductive connection portion
- 120: Cavity
- 130: First resin, e.g. ABF
- 140: Second resin, e.g. stack material
- 150: External boundary surface/region
- 151: Internal boundary surface/region
- 160: Pressing device

## Claims

1. A component carrier (100) comprising:
a stack (101) having at least one electrically conductive layer structure (104) and at least one electrically insulating layer structure (102);
a cavity (120) in the stack (101);
a component (110) embedded in the cavity (120); and
a first resin (130) extending from a bottom of the cavity (120) to at least part of the lateral side of the component (110) defining an external boundary surface (150);
wherein the component (110) comprises an external main surface (112) opposite to the bottom of the cavity (120), and
wherein the external boundary surface (150) is vertically misaligned with respect to the external main surface (112) of the component (110).

2. The component carrier (100) according to claim 1, further comprising:
a second resin (140), in particular a resin layer structure,
wherein one side of the second resin (140) is in contact with the component (110), one of the layer structures (102, 104) of the stack (101), and the first resin (130), thereby defining an internal boundary surface (151),
wherein the internal boundary surface (151) and the external boundary surface (150) defining a respective contact region.

3. The component carrier (100) according to one of the preceding claims,
wherein the first resin (130) extends only around the component (110), and/or
wherein the upper surface of the layer structure (102, 104) of the stack (101), defining the edge of the cavity (120), is free of the first resin (130).

4. The component carrier (100) according to one of the preceding claims, wherein the component carrier (100) further comprises:
a core layer structure in the stack (101), wherein the component (110) and the cavity (120) are arranged at least partially in said core layer structure; and/or
a build-up structure in the stack (101), wherein the component (110) and the cavity (120) are arranged at least partially in said build-up structure.

5. The component carrier (100) according to one of the preceding claims,
wherein the external boundary surface (150) is provided at the side of the component (110) that is in contact with the second resin (140); and/or
wherein the external boundary surface (150) extends along the direction between the component (110) and the cavity profile (120) defining a rounded shape, in particular a convex shape or a concave shape.

6. The component carrier (100) according to one of the preceding claims, further comprising:
residues of the first resin (130) are provided at the external main surface (111, 112) of the component (110) and/or at one side of the one of the layer structures (102, 104) being in contact with the second resin (140).

7. The component carrier (100) according to one of the preceding,
wherein the external main surface (112) of the component (110) is misaligned with respect to an adjacent layer structure of the stack (101), in particular the one of the layer structures (102) in contact with the second resin (140), which defines the cavity (120), in particular the upper edge of the cavity (120); and/or
wherein the external main surface (112) of the component (110) is below the adjacent layer structure of the stack (101), in particular the layer structure (102) in contact with the second resin (140), which defines the cavity (120), in particular the upper edge of the cavity (120).

8. The component carrier (100) according to one of the preceding claims,
wherein a portion of the first resin (130) overlaps and is in contact with the second external main surface (112) of the component (110).

9. The component carrier (100) according to one of the preceding claims,
wherein the component (110) comprises a surface with an electrically connecting portion (115), in particular a pad, at the second external main surface (112) of the component (110).

10. The component carrier (100) according to claim 9,
wherein the electrically connecting portion (115) is flush with the surface of the component (110); or
wherein the electrical connecting portion (115), in particular a pillar, protrudes from the surface of the component (110), in particular at least partially extending through the second resin (140).

11. The component carrier (100) according to one of the claims 2 to 10, further comprising:
a further layer structure on the second resin (140),
in particular, wherein the space between said second resin (140) and the component/adjacent layer is free of the further layer structure.

12. A method of manufacturing a component carrier (100), wherein the method comprises:
providing a stack (101) having at least one electrically conductive layer structure (104) and at least one electrically insulating layer structure (102) and a cavity (120
embedding the component (110) in the cavity (120); and
providing a first resin (130) to the component (110) and/or a bottom of the cavity (120), so that
the first resin (130) extends from the bottom of the cavity (120) to at least part of the lateral side of the component (110), thereby defining an external boundary surface (150),
the component (110) comprises an external main surface (112) opposite to the bottom of the cavity (120), and
the external boundary surface (150) is vertically misaligned with respect to the external main surface (112) of the component (110).

13. The method according to claim 12, further comprising:
controlling the temperature and/or pressure to thereby adjust the properties of the first resin (130).

14. The method according to claim 12 or 13, further comprising:
providing a second resin (140), in particular a resin layer structure,
so that the second resin (140) is in contact with the component (110), one of the layer structures (102) of the stack (101), and the first resin (130).

15. The method according to claim 14,
wherein the first resin (130) is cured before the second resin (140).
